# EUROPÄISCHE PATENTSCHRIFT

(11) **EP 2 583 358 B1**
(45) Veröffentlichungstag und Bekanntmachung des Hinweises auf die Patenterteilung: **12.09.2018**
(21) Anmeldenummer: 11729938.8
(22) Anmeldetag: 09.06.2011
(51) Int. Cl.: H01R 13/52, H01R 11/12, H05K 5/06, H01R 9/22

(54) **ELEKTRISCHE VERBINDUNGSVORRICHTUNG**
ELECTRICAL CONNECTING DEVICE
DISPOSITIF DE CONNEXION ÉLECTRIQUE

(30) Priorität: 16.06.2010 DE 102010023925
(43) Veröffentlichungstag der Anmeldung: 24.04.2013
(73) Patentinhaber: Continental Automotive GmbH, 30165 Hannover (DE)
(72) Erfinder: SCHMID, Thomas, 93051 Regensburg (DE); HERDEG, Björn, 93047 Regensburg (DE); SMIT, Arnoud, 93053 Regensburg (DE); RIEPL, Toni, 93342 Saal A. D. Donau (DE); GSCHOSSMANN, Hans, 93092 Barbing (DE); ZELLER, Robert, 93142 Maxhütte-Haidhof (DE); FENCHEL, Frank, 35510 Butzbach (DE)
(86) Internationale Anmeldenummer: PCT/EP2011/059621
(87) Internationale Veröffentlichungsnummer: WO 2011/157634

(56) Entgegenhaltungen:
- EP-A1- 0 681 342
- DE-A1- 3 518 216
- DE-A1- 3 841 528
- DE-U1- 20 318 855
- US-A1- 2008 149 387

## Beschreibung

Die vorliegende Erfindung betrifft eine elektrische Vorrichtung mit einer elektrischen bzw. elektronischen Komponente und einem diese Komponente umschließenden Gehäuse, wobei diese Vorrichtung eine luftdicht ausgeführte stabile elektrische Verbindung vom Gehäuseinneren in das Gehäuseäußere aufweist.

Gattungsgemäße Vorrichtungen werden nahezu in allen technischen Bereichen, insb. als Steuergeräte oder Energiespeicher eines Fahrzeugs, verwendet und weisen eine elektrische Verbindung auf, welche elektrische Signale oder elektrischen Strom vom Gehäuseinneren in das Gehäuseäußere oder umgekehrt leitet.

Elektrische bzw. elektronische Komponenten werden in der Regel in einem Gehäuse angeordnet, um diese von den Umfeldeinflüssen wie Staub, Feuchtigkeit etc. zu schützen. Um diese Komponenten vor äußeren Umfeldeinflüssen zu schützen, müssen die Gehäuse luftdicht verschlossen sein. Zudem sollen die Gehäuse die Komponenten vor Stößen schützen.

Dabei ist jedoch erforderlich, elektrische Verbindung von den im Innen des Gehäuses befindenden Komponenten zum außerhalb vom Gehäuse befindlichen Strom- oder Signalkabel herzustellen. Diese elektrische Verbindung wird in der Regel mithilfe eines am Kabelende angeordneten Kabelschuhs hergestellt, der mit einem elektrisch leitfähigen Stromleiter über einen Bolzen fest verbunden und elektrisch kurzgeschlossen ist.

Das Problem bei Herstellung einer elektrischen Verbindung zwischen einem außerhalb vom Gehäuse befindlichen stromführenden Kabel und einer elektrischen Komponente im Gehäuseinneren einer Steuergeräte oder einer Energiespeichereinheit eines Fahrzeugs mittels eines Kabelschuhs sind die sehr unterschiedlichen und gegensätzlichen Anforderungen an dem Kabelschuh.

Die Druckschrift DE 203 18 855 U1 beschreibt ein Anschlussmodul für Leistungsschalter, an dem ein Kabelschuh mithilfe einer Anschlussschraube befestigt ist.

Die Druckschrift US 2008/0149387 A1 beschreibt einen elektrischen Anschlusskasten, an dem ein Kabelschuh mithilfe eines Bolzens befestigt ist.

Der Kabelschuh muss mit einem großen Moment am Gehäuse der elektrischen Vorrichtung angeschraubt werden, um Bewegungen gegenüber den elektrischen Komponenten während des Betriebs der Vorrichtung zu verhindern und eine dauerhafte stabile elektrische Verbindung zwischen dem Kabel und den elektrischen Komponenten sicherzustellen.

Dabei darf die elektrische Verbindung während des Betriebs des Fahrzeugs nicht bewegen, weil sie mit der elektrischen bzw. elektronischen Komponente, wie z. B. Leiterplatte oder Batteriezelle, im Innen des Gehäuses hartgelötet wird, und diese Komponente wiederum keine Krafteinwirkung verträgt.

Zudem erwies sich die Stelle, wo die elektrische Verbindung vom Gehäuseinneren in das Gehäuseäußere ausgeführt ist, als Schwachstelle zur Abdichtung des Gehäuses der Vorrichtung.

Die derzeit weit verbreitete Methode zur Abdichtung der elektrischen Verbindungsstelle mit um den als elektrische Verbindung dienenden Stromleiter umspritztem Kunststoff gewährleistet keine dauerhafte Abdichtung des Gehäuses. Durch die nicht vermeidbaren Temperaturschwankungen in der Umgebung der Vorrichtung löst sich der um den Stromleiter herum angebrachte Kunststoffspritzguss vom Stromleiter und verliert dadurch seine Abdichtungswirkung.

Die Aufgabe der vorliegenden Erfindung liegt somit darin, eine elektrische Vorrichtung der eingangs genannten Art so zu modifizieren, dass dieses eine elektrische Verbindung aufweist, welche bei starken Temperaturschwankungen dauerhaft luftdicht verschlossen bleibt.

Demnach wird eine elektrische Vorrichtung mit zumindest einer elektrischen bzw. elektronischen Komponente und einem diese Komponente umschließenden Gehäuse geschaffen, wobei das Gehäuse an einer Seitenwand eine korbförmige Ausformung aufweist. Diese Ausformung weist am Boden eine erste Aussparung auf. Die Seitenwand des Gehäuses der Vorrichtung, an der die korbförmige

Ausformung angeformt ist, weist in dem Bereich, wo der Boden der korbförmigen Ausformung mit der ersten Aussparung ist, eine zweite Aussparung, wobei diese zweite Aussparung durch die Seitenwand hindurchgeht und die Räume von der ersten Aussparung und dem Gehäuseinneren miteinander verbindet.

Durch diese zweite Aussparung ragt ein elektrischer Stromleiter vom Gehäuseinneren in die erste Aussparung heraus, wobei dieser Stromleiter mit der im Gehäuseinneren befindlichen elektrischen bzw. elektronischen Komponente elektrisch kontaktiert ist und mit dem in der ersten Aussparung befindlichen Abschnitt in einer Verankerung in der ersten Aussparung verankert ist. Die erste Aussparung ist mithilfe von zumindest einem Abdichtungsmittel abgedichtet. Als Abdichtungsmittel dienen vorzugsweise ein metallischer Abdichtungsring und eine Abdichtungskappe, wobei der Abdichtungsring und die Abdichtungskappe an den beiden Öffnungen der ersten Aussparung angeordnet sind und diese Aussparung von beiden Seiten verschließt bzw. luftdicht abdichtet. Vorzugweise ist der Abdichtungsring in die erste Aussparung verstemmt und/oder mit einem O-Ring überzogen. Dabei weist der Abdichtungsring an der Seitenwand eine ringförmige geschlossene einstückig ausgeführte Nut auf, wobei in dieser Nut ein O-Ring überzogen ist. Dieser O-Ring dichtet den Zwischenraum zwischen dem Abdichtungsring und der ersten Aussparung luftdicht ab.

Der Abdichtungsring samt dem O-Ring und die Abdichtungskappe verschließen bzw. dichten so die erste Aussparung und somit auch die zweite Aussparung sowie das Gehäuseinneren von dem Umfeld außerhalb vom Gehäuse luftdicht ab.

Dadurch ist eine elektrische Vorrichtung mit einer elektrischen Verbindung geschaffen, welche eine elektrische Strom- bzw. Signalübertragung zwischen den im Gehäuseinneren befindlichen elektrischen bzw. elektronischen Komponenten und den elektrischen bzw. elektronischen Vorrichtungen außerhalb vom Gehäuse ermöglicht, wobei die Stelle am Gehäuse, wo diese Verbindung ins Gehäuseinneren eingeführt wird, bei starken Temperaturschwankungen dauerhaft luftdicht verschlossen bleibt zudem stabil und stoßfest ist.

Vorteilhafterweise ist die Verankerung eine Nut, welche in der ersten Aussparung an der der zweiten Aussparung gegenüber liegenden Seite der ersten Aussparung angeordnet ist und an diese Nut der Stromleiter fest und bewegungsfrei verankert ist.

Der Abdichtungsring weist ein durchgehendes Loch auf, wobei durch dieses Loch und durch eine entsprechende Stelle am Stromleiter ein elektrisch leitender Bolzen durchragt und den

Abdichtungsring mit dem Stromleiter formschlüssig und elektrisch leitend verbindet. Dieser Bolzen ist vorzugsweise in das Loch am Abdichtungsring und in den Stromleiter verstemmt. Über den Abdichtungsring ist ein Kabelschuh aufgelegt, wobei der Kabelschuh ein ringförmiges Loch aufweist und durch dieses Loch der Bolzen hinausragt und elektrische Verbindung vom elektrischen Kabel zum Abdichtungsring herstellt. Auf den Bolzen und über den Kabelschuh ist eine Bolzenmutter verschraubt, wobei diese Bolzenmutter den Kabelschuh mit dem Abdichtungsring formschlüssig und elektrisch leitend verbindet.

An einer Seitenwand, welche nicht gleich die Seitenwand des Gehäuses ist, weist die korbförmige Ausformung eine dritte Aussparung auf, wobei durch diese dritte Aussparung der Kabelschuh samt dem Kabel in die korbförmige Ausformung eingeführt ist.

Der Stromleiter, der Abdichtungsring, der Kabelschuh und ggfs. der Bolzen bestehen aus niederohmigen Materialien und sind ausgeführt, dass die aus diesen Teilen bestehende elektrische Verbindung einen Stromfluss von mehr als 1000 Ampere innerhalb von einer kurzen Stromflussdauer von einigen Sekunden und mit einem sehr niedrigen Innenwiderstand somit auch mit sehr geringem Leistungsverlust ermöglicht. Vorzugsweise realisiert die elektrische Verbindung den Stromfluss zwischen einer in einem geschlossenen Gehäuse befindlichen elektrischen bzw. elektronischen Komponente wie z. B. Batteriezelle oder Leiterplatte zu einem außerhalb vom Gehäuse befindlichen Kabelschuh über einen Stromleiter aus niederohmigem Metall bspw. Aluminium oder Kupfer.

Im Folgenden wird die Erfindung anhand eines Ausführungsbeispiels unter Zuhilfenahme von Figuren näher erläutet. Als Ausführungsbeispiel dient eine Energiespeichervorrichtung eines Fahrzeugs. Es zeigt,
- Figur 1: Querschnittansicht einer Seitenwand des Gehäuses der erfindungsgemäßen Energiespeichervorrichtung mit der angeformten korbförmigen Ausformung,
- Figur 2: Querschnittansicht der Seitenwand nach Figur 1 mit erfindungsgemäßer elektrischer Verbindung
- Figur 3: den Abdichtungsring in schräger Draufsicht.

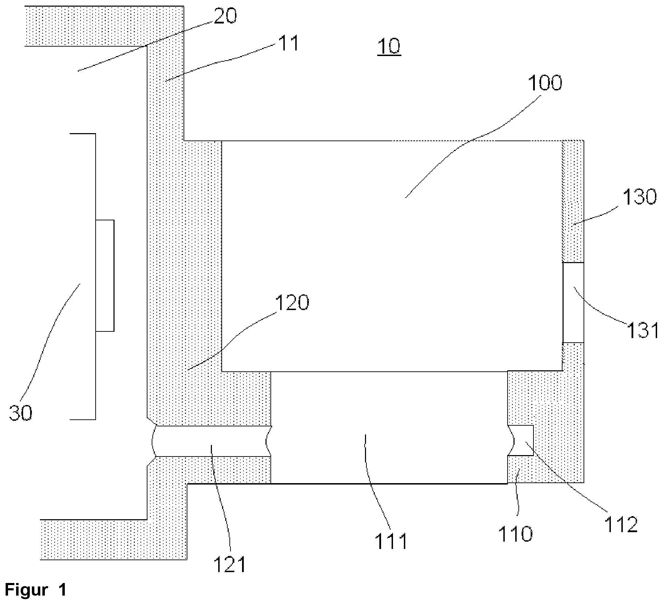

Das Gehäuse 10 der erfindungsgemäßen Energiespeichervorrichtung für elektrische bzw. elektronische Komponente 30 wie z. B. Batteriezelle, Leiterplatte, weist gemäß Figur 1 an einer Seitenwand 11 eine korbförmige Ausformung 100 auf. Die korbförmige Ausformung 100 weist eine erste kreisförmige Aussparung 111 bzw. ein erstes Loch am Korbboden 110 auf. Zwischen der Aussparung 111 am Boden 110 der Ausformung 100 und dem Gehäuseinneren 20 bzw. an der Seitenwand 11 des Gehäuses 10 zur Aussparung 111 am Boden 110 der Ausformung 100, welche zugleich Seitenwand 120 der Ausformung 100 ist eine zweite schlitzförmige Aussparung 121 also ein zweites schlitzförmiges Loch angebracht, wobei durch diese Aussparung 121 bzw. dieses Loch das balkenförmige Stromleiter 500 aus dem Gehäuseinneren 20 ins Gehäuseaußen hinausgeführt ist. Die Querschnittsformen der zweiten Aussparung 121 und des Stromleiters 500 sind zueinander angepasst. Vorzugsweise weisen die zweite Aussparung 121 und der Stromleiter 500 die gleiche Querschnittsform auf. Der Stromleiter 500 besteht bspw. aus einem Stanzgitter, welcher aus einem Aluminiumstreifen ausgestanzt wurde.

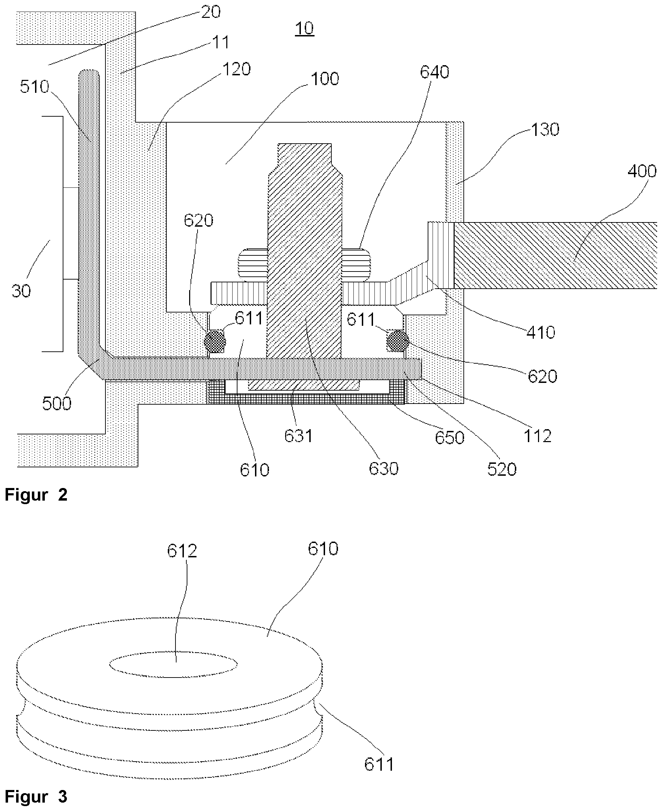

An der der zweiten Aussparung 121 gegenüberliegenden Wand der ersten Aussparung 111 ist eine Nut 112 angeformt, wobei an diese Nut 112 ein Ende des Stromleiters 500 fest und bewegungsfrei verankert ist, wie es die Figur 2 zeigt.

In der ersten Aussparung 111 ist ein metallischer Abdichtungsring 610 angeordnet, wobei dieser vorzugsweise in die Aussparung 111 verstemmt ist. Der Abdichtungsring 610 weist an der Seitenwand eine ringförmige geschlossene einstückig ausgeführte Nut 611 auf, wobei auf dieser Nut 611 ein handelsüblicher O-Ring 620 aus Gummi zur besseren Abdichtung der ersten Aussparung 111 überzogen ist. Der Abdichtungsring 610 besteht aus elektrisch leitendem Material, bspw. Metall und dient zur Herstellung elektrischen Kontakts zwischen einem Kabelschuh 410 und dem Stromleiter 500.

Der Abdichtungsring 610 weist in der Mitte ein durchgehendes Loch 612 auf, wobei durch dieses Loch 612 und durch die entsprechende Stelle am Stromleiter 500 und Kabelschuh 410 ein Bolzen 630 durchragt und den Kabelschuh 410 mit dem Stromleiter 500 formschlüssig und elektrisch leitend verbindet, wobei dieser Bolzen 630 vorzugsweise in das Loch 612 am Abdichtungsring 610 und in den Stromleiter 500 bzw. in den Kabelschuh 410 verstemmt ist.

Über den Kabelschuh ist eine Bolzenmutter 640 auf den Bolzen 630 verschraubt. Durch die Verankerung des Stromleiters 500 in der Nut 112 der Aussparung 111 am Boden 110 der Ausformung 100 sowie die Verkeilung des Bolzens 630 in den Stromleiter 500 durch die Verstemmung drehen der Bolzen 630 und der Stromleiter 500 beim Auswirken eines relativ hohen Drehmoments beim Verschrauben von Bolzenmutter 640 nicht mit.

Vorzugsweise weist die korbförmige Ausformung 100 an der Seitenwand 130, welche nicht gleich die Seitenwand 11 des Gehäuses 10 ist, eine dritte Aussparung 131 auf, durch die der Kabelschuh 410 samt dem Kabel 400 in die Ausformung 100 eingeführt ist.

Über den Bolzenkopf 631 ist eine Abdichtungskappe 650 angeordnet, welche mit dem Abdichtungsring 610 bzw. dem O-Ring 620 die beiden Aussparungen 111, 121 am Boden 110 der korbförmigen Ausformung 110 sowie an der Gehäuseseitenwand 11 luftdicht abdichtet und so das Gehäuseinneren 20 vor Eindringen von Feuchtigkeit oder Staub schützt und zudem verhindert, dass der aluminiumhaltige Stromleiter 500 mit der Luft vom Gehäuseaußen in Berührung kommt und oxidiert.

Durch die Anwendung eines niederohmigen Abdichtungsrings 610, welcher sowohl mit dem Stromleiter 500 als auch mit dem Kabelschuh 410 großflächig elektrisch kontaktiert ist und durch den in den Stromleiter 500 verstemmten Bolzen 630 mit der über den Kabelschuh 410 fest geschraubten Bolzenmutter 640 ist eine niederohmige elektrische Verbindung vom Stromleiter 500 über den Abdichtungsring 610 zum Kabelschuh 410 somit eine niederohmige elektrische Verbindung von der Batteriezelle 30 im Innen des Gehäuses 20 zu dem Stromkabel 400 geschaffen, welcher zugleich stabil und luftdicht abgedichtet ist.

Der Abdichtungsring 610 verformt sich durch das Verstemmen des Bolzens 630 um den Bolzen 630 rum. Dadurch kriegt der Bolzen 630 mehr halt und wird der Widerstand gegen Verdrehen des Bolzens 630 erhöht. Zudem ist durch das Verstemmen des Bolzens 630 in den Abdichtungsring 610 eine luftdichte korrosionsbeständige großflächige und somit niederohmige Verbindung zwischen dem Abdichtungsring 610 und dem Stromleiter 500 geschaffen.

Es ist eine elektrische Verbindung für eine in einem geschlossenen Gehäuse 10 angeordnete elektrische bzw. elektronische Komponente wie z. B. Batteriezelle, Leiterplatte 30 geschaffen, welche die Anforderungen auf hohe Dichtung, niedrigen Stromübergangswiderstand, hohe Drehmomentfestigkeit, guten Korrosionsschutz bei den Komponenten der elektrischen Verbindung erfüllt.

### Bezugszeichenliste:

10 Gehäuse
11 Seitenwand vom Gehäuse
100 Korbförmige Ausformung an der Seitenwand vom Gehäuse
110 Boden der Ausformung
111 Erste Aussparung am Boden der Ausformung
112 Nut an der Seitenwand der ersten Ausformung
120 Seitenwand der Ausformung, welche zugleich Teil der Seitenwand vom Gehäuse ist
121 Zweite Aussparung an der Seitenwand der Ausformung
130 Seitenwand der Ausformung, welche nicht Teil der Seitenwand vom Gehäuse ist
131 Dritte Aussparung an der Seitenwand der Ausformung
20 Gehäuseinneren
30 Elektrische Komponente im Gehäuseinneren, Batteriezelle
400 Stromkabel
410 Kabelschuh
500 Stromleiter
510 Im Gehäuseinneren befindlicher Abschnitt des Stromleiters
520 Ende des im Gehäuseäußeren befindlichen Abschnitts des Stromleiters
610 Abdichtungsring
611 Nut am Abdichtungsring
612 Loch am Abdichtungsring
620 O-Ring
630 Bolzen
631 Bolzenkopf
640 Bolzenmutter
650 Abdichtungskappe

## Patentansprüche

1. Elektrische Vorrichtung mit einer elektrischen bzw. elektronischen Komponente (30) und einem Gehäuse (10), wobei in diesem Gehäuse (10) die Komponente (30) angeordnet ist,
- wobei das Gehäuse (10) an einer Seitenwand (11) eine korbförmige Ausformung (100) aufweist,
- wobei die Ausformung (100) am Boden (110) eine erste Aussparung (111) aufweist und die Seitenwand (11) des Gehäuses (10) in dem mit dieser ersten Aussparung (111) angrenzenden Bereich (120) eine die erste Aussparung (111) mit dem Gehäuseinneren (20) verbindende zweite Aussparung (121) aufweist,
- wobei durch diese zweite Aussparung (121) ein elektrischer Stromleiter (500) vom Gehäuseinneren (20) in die erste Aussparung (111) herausragt,
- wobei der Stromleiter (500) mit der im Gehäuseinneren (20) befindlichen elektrischen bzw. elektronischen Komponente (30) elektrisch kontaktiert ist,
**dadurch gekennzeichnet, dass**
- der Stromleiter (500) mit dem in der ersten Aussparung (111) befindlichen Abschnitt (520) in einer Verankerung (112) in der ersten Aussparung (111) verankert ist,
- wobei die erste Aussparung (111) mithilfe von zumindest einem Abdichtungsmittel (610, 620, 650) abgedichtet ist,
- wobei ein Abdichtungsring (610) in der ersten Aussparung (111) angeordnet ist, der als Abdichtungsmittel ausgeführt ist, um die erste Aussparung (111) abzudichten.

2. Elektrische Vorrichtung nach Anspruch 1, wobei die Verankerung (112) eine in der ersten Aussparung (111) an der der zweiten Aussparung (121) gegenüber liegenden Seite der ersten Aussparung (111) angeordnete Nut (112) ist, wobei an diese Nut (112) der Stromleiter (500) fest und bewegungsfrei verankert ist.

3. Elektrische Vorrichtung nach Anspruch 1 oder 2, wobei der Abdichtungsring (610) an der Seitenwand eine ringförmige geschlossene einstückig ausgeführte Nut (611) aufweist, wobei in dieser Nut (611) ein O-Ring (620) überzogen ist.

4. Elektrische Vorrichtung nach einem der Ansprüche 1 bis 3, wobei der Abdichtungsring (610) elektrisch leitend ist.

5. Elektrische Vorrichtung nach einem der Ansprüche 1 bis 4, wobei der Abdichtungsring (610) ein durchgehendes Loch (612) aufweist, wobei durch dieses Loch (612) und durch die entsprechende Stelle am Stromleiter (500) ein Bolzen (630) durchragt und den Abdichtungsring (610) mit dem Stromleiter (500) formschlüssig und elektrisch leitend verbindet.

6. Elektrische Vorrichtung nach Anspruch 5, wobei dieser Bolzen (630) in das Loch (612) am Abdichtungsring (610) und in den Stromleiter (500) verstemmt ist.

7. Elektrische Vorrichtung nach Anspruch 4 oder 5, wobei über den Abdichtungsring (610) ein Kabelschuh (410) aufgelegt ist, wobei der Kabelschuh (410) ein ringförmiges Loch aufweist und durch dieses Loch der Bolzen (630) hinausragt und elektrische Verbindung vom elektrischen Kabel (400) zum Abdichtungsring (610) herstellt.

8. Elektrische Vorrichtung nach Anspruch 7, wobei auf den Bolzen (630) und über den Kabelschuh (410) eine Bolzenmutter (640) verschraubt ist, wobei diese Bolzenmutter (640) den Kabelschuh (410) mit dem Abdichtungsring (610) formschlüssig und elektrisch leitend verbindet.

9. Elektrische Vorrichtung nach Anspruch 7 oder 8, wobei die korbförmige Ausformung (100) an einer Seitenwand (130), welche nicht gleich die Seitenwand (11) des Gehäuses (10) ist, eine dritte Aussparung (131) aufweist, wobei durch diese dritte Aussparung (131) der Kabelschuh (410) samt dem Kabel (400) in die korbförmige Ausformung (100) eingeführt ist.

10. Elektrische Vorrichtung nach einem der Ansprüche 3 bis 9, wobei die erste Aussparung (111) am Boden (110) der Ausformung (100) auf der Seite, wo sich kein Abdichtungsring (610) befindet, mit einer Abdichtungskappe (650) abgedeckt ist, wobei die Abdichtungskappe (650) mit dem Abdichtungsring (610) bzw. dem O-Ring (620) am Abdichtungsring (610) die erste Aussparung (111) und somit auch die zweite Aussparung (121) an der Gehäuseseitenwand (11, 120) sowie Gehäuseinneren (20) luftdicht abdichtet.

## Claims

1. Electrical device comprising an electrical or electronic component (30) and a housing (10), the component being arranged in this housing (10),
- wherein the housing (10) has a basket-like shaped portion (100) on a side wall (11),
- wherein the shaped portion (100) has a first cutout (111) at the bottom (110), and the side wall (11) of the housing (10) has in the region (120) which is adjacent to this first cutout (111) a second cutout (121), which connects the first cutout (111) to the housing interior (20),
- wherein an electrical current conductor (500) projects from the housing interior (20) into the first cutout (111) through this second cutout (121),
- wherein the current conductor (500) is in electrical contact with the electrical or electronic component (30) located in the housing interior (20),
**characterized in that**
- the current conductor (500) is anchored by the portion (520) located in the first cutout (111) in an anchorage (112) in the first cutout (111),
- wherein the first cutout (111) is sealed off with the aid of at least one sealing means (610, 620, 650),
- wherein a sealing ring (610) is arranged in the first cutout (111) and is designed as a sealing means to seal off the first cutout (111).

2. Electrical device according to Claim 1, wherein the anchorage (112) is a groove (112) arranged in the first cutout (111), on the side of the first cutout (111) opposite from the second cutout (121), wherein the current conductor (500) is securely and immovably anchored to this groove (12).

3. Electrical device according to Claim 1 or 2, wherein the sealing ring (610) has on the side wall an annular, closed integrally formed groove (611), an O-ring (620) being enclosed in this groove (611).

4. Electrical device according to one of Claims 1 to 3, wherein the sealing ring (610) is electrically conducting.

5. Electrical device according to one of Claims 1 to 4, wherein the sealing ring (610) has a through-hole (612), wherein a bolt (630) penetrates through this hole (612) and through the corresponding location on the current conductor (500) and connects the sealing ring (610) to the current conductor (500) in a form-fitting and electrically conducting manner.

6. Electrical device according to Claim 5, wherein this bolt (630) is caulked in the hole (612) on the sealing ring (610) and in the current conductor (500).

7. Electrical device according to Claim 4 or 5, wherein a cable shoe (410) is placed over the sealing ring (610), wherein the cable shoe (410) has an annular hole and the bolt (630) protrudes through this hole and establishes the electrical connection from the electrical cable (400) to the sealing ring (610).

8. Electrical device according to Claim 7, wherein a bolt nut (640) is screwed onto the bolt (630) and over the cable shoe (410), wherein this bolt nut (640) connects the cable shoe (410) to the sealing ring (610) in a form-fitting and electrically conducting manner.

9. Electrical device according to Claim 7 or 8, wherein the basket-like shaped portion (100) has on a side wall (130) that is not the side wall (11) of the housing (10) a third cutout (131), wherein the cable shoe (410) together with the cable (400) is inserted into the basket-like shaped portion (100) through this third cutout (131).

10. Electrical device according to one of Claims 3 to 9, wherein the first cutout (111) at the bottom (110) of the shaped portion (100) is covered by a sealing cap (650) on the side where there is no sealing ring (610), wherein the sealing cap (650) together with the sealing ring (610), or the O-ring (620) on the sealing ring (610), seals off the first cutout (111) and consequently also the second cutout (121) on the housing side wall (11, 120) and the housing interior (20) in an airtight manner.

## Revendications

1. Dispositif électrique comportant des composants (30) électriques ou électroniques et un boîtier (10), dans lequel les composants (30) sont disposés dans ledit boîtier (10),
- dans lequel le boîtier (10) comporte sur sa paroi avant (11) une déformation (100) en forme de panier,
- dans lequel la déformation (100) comporte au niveau du fond (110) un premier évidement (111) et la paroi latérale (11) du boîtier (10) comporte, dans la zone (120) adjacente au premier évidement (111), un deuxième évidement (121) reliant la premier évidement (111) à l'intérieur du boîtier (20),
- dans lequel un conducteur de courant électrique (500) fait saillie hors de l'intérieur du boîtier (20) en passant dans le premier évidement (111) à travers le deuxième évidement (121),
- dans lequel le premier conducteur de courant (500) est mis en contact électrique avec les composants (30) électriques ou électroniques se trouvant à l'intérieur (20) du boîtier,
**caractérisé en ce que**
- le conducteur de courant (500) est ancré sur la partie (520) se trouvant dans le premier évidement (111) dans un dispositif d'ancrage (112) prévu dans le premier évidement (111),
- dans lequel le premier évidement (111) est rendu étanche à l'aide d'au moins un moyen d'étanchéité (610, 620, 650),
- dans lequel une bague d'étanchéité (610) est disposée dans le premier évidement (111), laquelle bague d'étanchéité est réalisée sous la forme de moyens d'étanchéité permettant de rendre étanche le premier évidement (111).

2. Dispositif électrique selon la revendication 1, dans lequel le dispositif d'ancrage (112) est une rainure (112) disposée dans le premier évidement (111) au niveau de la face du premier évidement (111) qui est opposée au deuxième évidement (121), dans lequel le conducteur de courant (500) est ancré de manière rigide et de manière immobilisée au niveau de ladite rainure (112).

3. Dispositif électrique selon la revendication 1 ou 2, dans lequel la bague d'étanchéité (610) comporte une rainure (611) annulaire fermée réalisée d'un seul tenant au niveau de la paroi latérale, dans lequel un joint torique (620) est appliqué dans ladite rainure (611).

4. Dispositif électrique selon l'une des revendications 1 à 3, dans lequel la bague d'étanchéité (610) est électriquement conductrice.

5. Dispositif électrique selon l'une des revendications 1 à 4, dans lequel la bague d'étanchéité (610) comporte un trou traversant (612), dans lequel un boulon (630) passe à travers ledit trou (612) et par l'emplacement correspondant du conducteur de courant (500) et relie par complémentarité de forme et de manière électriquement conductrice la bague d'étanchéité (610) au conducteur de courant (500).

6. Dispositif électrique selon la revendication 5, dans lequel ledit boulon (630) est scellé dans le trou (612) au niveau de la bague d'étanchéité (610) et dans le conducteur de courant (500).

7. Dispositif électrique selon la revendication 4 ou 5, dans lequel une cosse de câble (410) est appliquée sur la bague d'étanchéité (610), dans lequel la cosse de câble (410) comporte un trou annulaire et dans lequel le boulon (630) fait saillie à travers ledit trou et établit une liaison électrique entre le câble électrique (400) et la bague d'étanchéité (610) .

8. Dispositif électrique selon la revendication 7, dans lequel un écrou de boulon (640) est vissé sur le boulon (630) et sur la cosse de câble (410), dans lequel ledit écrou de boulon (640) relie la cosse de câble (410) à la bague d'étanchéité (610) par complémentarité de forme et de manière électriquement conductrice.

9. Dispositif électrique selon la revendication 7 ou 8, dans lequel la déformation en forme de panier (100) comporte un troisième évidement (131) au niveau d'une paroi latérale (130) qui n'est pas identique à la paroi latérale (11) du boîtier (10), dans lequel la cosse de câble (410) est introduite en association avec le câble (400) dans la déformation en forme de panier (100) à travers ledit troisième évidement (131).

10. Dispositif électrique selon l'une des revendications 3 à 9, dans lequel le premier évidement (111) est recouvert d'un capuchon d'étanchéité (650) au fond (110) de la déformation (100) du côté où ne se trouve aucune bague d'étanchéité (610), dans lequel le capuchon d'étanchéité (650), avec la bague d'étanchéité (610) ou le joint torique (620), au niveau de la bague d'étanchéité (610), rend étanche le premier évidement (111) et par conséquent, le deuxième évidement (121) au niveau de la paroi latérale de boîtier (11, 120), ainsi que l'intérieur du boîtier (20).
